Europäisches Patentamt

European Patent Office

Office européen des brevets

(11) Publication number: **0 493 964 A2**

# EUROPEAN PATENT APPLICATION

(21) Application number: **91311991.3**

(22) Date of filing: **23.12.91**

(51) Int. Cl.5: **G01R 21/00**

(30) Priority: **31.12.90 US 636511**

(43) Date of publication of application:
**08.07.92 Bulletin 92/28**

(84) Designated Contracting States:
**DE FR GB IT**

(71) Applicant: **RAYTHEON COMPANY**
**141 Spring Street**
**Lexington Massachusetts 02173(US)**

(72) Inventor: **Gilfix, Edward L.**
**42 Peacock Farm Road**
**Lexington, Massachusetts(US)**

(74) Representative: **Jackson, David Spence et al**
**REDDIE & GROSE 16, Theobalds Road**
**London, WC1X 8PL(GB)**

(54) **Automated power system.**

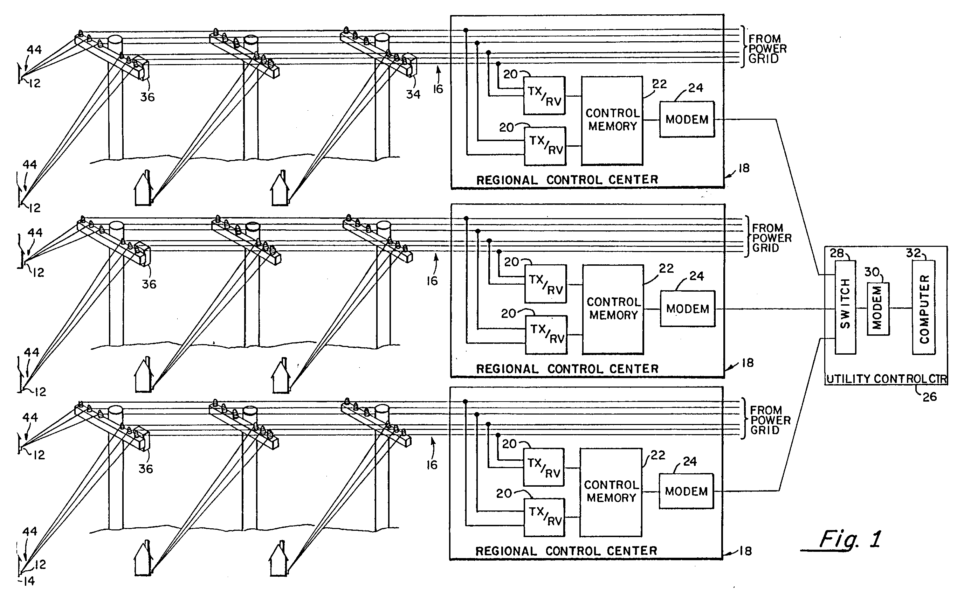

(57) An integrated automated meter and load management system comprises terminal units (10) mounted to existing power meters (12). Power usage indicated by the meter (12) is tracked by the terminal unit (10) by tracking rotations of the calibration wheel (42) of the meter (12). Messages representing incremental power usage are transmitted by the terminal unit (10) to a regional control center (18, Fig. 1) over the power lines (16) using a time division multiple access scheme synchronized to the frequency of the power signal. The system includes an initialization unit (64, Fig. 6) for entering through an initialization port 56 the value on the meter (12) when the terminal unit (10) is installed, thereby allowing the control center to track cumulative power usuage. In one embodiment, the terminal unit (10) comprises a load control unit (58) which through load control lines 60 can disconnect loads from the power system in response to commands from the regional control center (18). The regional control center (18) acts as a local communications relay station in relation to a remote central utility control center (26, Fig. 1).

FIG. 2

## Background of the Invention

This application relates generally to electric power distribution systems and more particularly to systems for automatically measuring and controlling power used at a plurality of locations.

Various problems face electric utility companies. One problem is that of measuring how much power each customer consumed. Currently, each customer has a power meter installed at the customer's location. Nearly all of these meters are read by periodically sending a person to each customer's location to read the value on the meter. These readings are used for billing customers.

This system has several disadvantages. It is very expensive to send a person to each customer's location. Sometimes, power meters are installed in places where a meter reader cannot easily gain access. For example, it has been estimated that as many as ten percent of the power meters in New York City are in high crime rate areas or locked areas to which the utility company does not have ready access. Moreover, having the power meter at the customer's location gives the customer ready access to the meter. Some unscrupulous customers tamper with their power meters to prevent the meter from recording power actually used.

Another problem facing electric utility companies is supplying all of the power needs of all their customers simultaneously. Peak power usage for most customers occurs generally at the same time each day. Power companies must have extra equipment to generate all the power needed to provide customers with power during the peak periods. However, if power usage were spread evenly over the day, the extra equipment would not be needed. This extra equipment is very costly to have on hand.

## Summary of the Invention

With the foregoing background in mind, it is an object of this invention to provide a system for automatic meter reading which does not require replacement of existing power meters.

It is an object of this invention to provide a protocol for digital communication between a device located in a power meter at a customer location and a device at a regional center for collecting information on many meters.

It is a further object of this invention to provide a system for automatic meter reading which can be added to the existing power distribution system in small areas.

It is yet another object of this invention to provide a system which detects the theft of electric power or local power outages.

It is still a further object of this invention to provide a system which can reduce the peak load on the power system.

The foregoing and other objects are achieved by a system comprising terminal units added to existing power meters, regional control centers connected via the power lines to a plurality of terminal units, and a utility control center linked to a plurality of regional control centers. Each terminal unit tracks power measured by its associated meter and sends a code to a regional control center. Information is conveyed between the terminal units and regional control center over the power line using a time division multiple access code synchronized to the 60Hz a.c. voltage on the power line. The information is encoded to provide information for normal billing, time of day billing, and detection of power outages or theft of services.

## Brief Description of the Drawings

The invention will be better understood by reference to the following more detailed description and accompanying drawings in which

FIG. 1 is a simplified block diagram of a system incorporating the invention;

FIG. 2 is a simplified sketch of a power meter modified to incorporate a terminal unit according to the invention;

FIG. 3 is a block diagram of the terminal unit of FIG. 2;

FIG. 4 is a sketch useful in understanding the protocol for transferring information between a terminal unit and a regional control center as shown in FIG. 1;

FIG. 5 is a sketch useful in understanding the protocol for transferring information between a terminal unit and a regional control center as shown in FIG. 1; and

FIG. 6 is a block diagram of an installation useful in conjunction with the terminal unit of FIG. 3.

## Description of the Preferred Embodiments

Turning now to FIG. 1, a block diagram of an electric power distribution system is shown. Electric power is delivered to many customer locations 14. The electric power comes from the power grid. The grid comprises power lines which branch out to cover various regions. At the top level of the power grid, power lines may supply power to several states. As the lines branch out, the lines get smaller and cover smaller geographic areas. At the lowest level, power lines run to individual customer locations 14 with each power line supplying a small number of customer locations. In FIG. 1, power lines supplying customer locations are denoted 16 and are shown to each connect to three customer locations 14. However, it will be understood that many more power lines exist and that they connect to many more customer locations.

The power lines are connected to the customer location 14 through a power meter 12. The power meter 12 measures the amount of power used at its associated customer location 14.

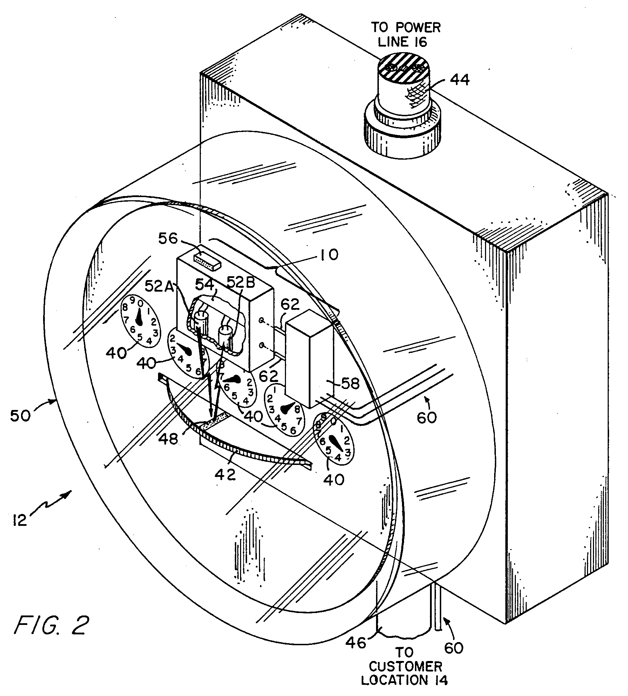

According to the invention, power meter 12 contains a terminal unit 10 (FIG. 2) to transmit and receive information over power lines 16. The exact type of information will be described in detail below. Suffice it to say here that the information sent from power meter 12 describes power used at a corresponding customer location 14. Information received at power meter 12 acts as commands to control the amount of electricity used at any given time at the corresponding customer location.

Information is received from and sent to meter 12 from a regional control center 18. Each of the regional control centers is connected to a power line 16 and is therefore connected to a plurality of customer locations 14. Here, three customer locations are shown to be connected to each regional control center 18. In a practical implementation of the invention, around 2,000 meters 12 are connected to each regional control center 18. For the specific numbers used herein, a maximum of 2,047 meters 12 may be connected to each regional control center.

A regional control center 18 represents apparatus not currently a part of the electric power distribution system. However, a regional control center 18 can be incorporated into existing equipment owned by power companies. For example, regional control center might be incorporated into existing transformer stations or other convenient locations.

Regional control center 18 contains a transceiver 20 connected to the power line 16. FIG. 1 shows two transceivers 20, one connected to each power line running to customer locations 14. Separate transceivers may not be required. For example, if two power lines running to customer locations are combined at some point, one transceiver can be connected to the combined line. Alternatively, one transceiver could be connected to a plurality of power lines 16 through a multiplexer (not shown).

Transceiver 20 is a half duplex digital phase shift keyed (DPSK) transceiver. Transceiver 20 operates with a bit rate of 360 bits per second. This transmission frequency is selected to be an integer multiple of the power line frequency of 60Hz. In this way, every transceiver connected to the power line is synchronized to the same frequency reference. The frequency at which transceiver 20 operates is selected so that information can be readily distinguished from the 60 HZ signals on power lines 16. Transceiver 20 may operate at any one of a plurality, say five, of frequencies. In this way, regional control centers which are physically located in close proximity can be operated with different frequencies. Thus, the chance of cross talk between regional control centers is reduced.

Information about electricity usage sent by meters 12 and received at transceivers 20 is passed to control/memory circuit 22. Control/memory circuit 22 is conventional digital logic circuitry which performs functions described below. For example, control/memory circuit 22 could be a conventional microprocessor, ASIC, or discrete integrated circuit chips. -

Control/memory circuit 22 contains at least one memory location corresponding to each customer location 14 connected to it through a power line 16. One memory location for each customer location stores the cumulative power used by that customer location. Information on power usage at each customer location is provided by the corresponding power meter 12. When a "unit" of power, say one kiloWatt, is used at a customer location, the corresponding meter 12 transmits a message to regional control center 18 indicating one unit of power has been consumed. Control/memory circuit 22 responds to this message by increasing, by one unit of power, the value stored in the memory location corresponding to that customer location 14.

Control/memory circuit 22 is connected through modem 24 to a utility control center 26. As shown in FIG. 1, several regional control centers 18 are connected to utility control center 26. An electric power company will have many regional control centers but only one utility control center 26 in any geographic area. Utility control center is preferably located at the utility company's business office.

Modem 24 might be a modem of the type used to transmit and receive information over a telephone line. In that case, regional control center 18 is connected to utility control center 26 through telephone lines. However, other communication media can be used to connect regional control center 18 and utility control center 26. For example, a radio link could be used.

Utility control center 26 contains a switch 28 connecting modem 30 to a plurality of regional control centers 18. Modem 30 is like modem 24 and sends and receives messages for computer 32.

Computer 32 is a general purpose digital computer and performs functions described in greater detail below. Computer 32 receives information from regional control center 18 about power usage at each of the customer locations 14. Computer 32 is programmed to use this information to generate bills to customers and detect power failures or theft of services. Also, this information on energy usage can be processed to determine when power at the peak capacity of the power grid is being consumed at customer locations 14. If computer 32 determines the power system is reaching its peak capacity, it may alert utility company employees or send commands to regional control centers 18 which in turn cause the regional control centers 18 to send commands to meters 12 to reduce power consumption by shutting off the power to various electrical appliances at the customer location 14.

In FIG. 1, it should be noted that each customer location 14 is shown connected to a power line 16 which is also connected to a regional control center 18. It is, of course, not necessary for all customer locations 14 to be connected to a regional control center. Some customer locations can be connected to regional control center 18 and use the advantages of this invention while other customer locations are not connected to a regional control center 18. This flexibility allows the invention to be incorporated slowly or only in regions where a person cannot easily gain access to meters at customer locations to read them.

Turning now to FIG. 2, power meter 12 modified to function in conjunction with the system of the invention is shown. Power meter 12 is connected to power line 16 through a cable 44. Electrical devices at customer location 14 are connected via cable 46 as in a conventional meter. Power meter 12 measures the power used by the electrical devices.

That amount of power is displayed on dials 40 which record the number of kiloWatt hours of electricity used at customer location 14. Face portion 50 of meter 12 is usually sealed in a glass enclosure (not shown). The glass enclosure protects face portion 50 from environmental conditions, but allows a person to read the values indicated by dials 40.

Meter 12 also contains a calibration wheel 42. Calibration wheel 42 contains a black stripe 48 which allows one to determine how quickly calibration wheel 42 is rotating. The speed of rotation of calibration wheel 42 is directly related to the amount of power flowing through meter 12. For example, for a certain brand of meter, calibration wheel 42 may rotate once for each kiloWatt hour of power passing through meter 12.

One of skill in the art will recognize that the foregoing describes a conventional meter. It is contemplated that meter 12 is actually an existing, conventional meter already installed at a customer location. The existing meter is modified by the addition of a terminal unit 10 mounted to face portion 50.

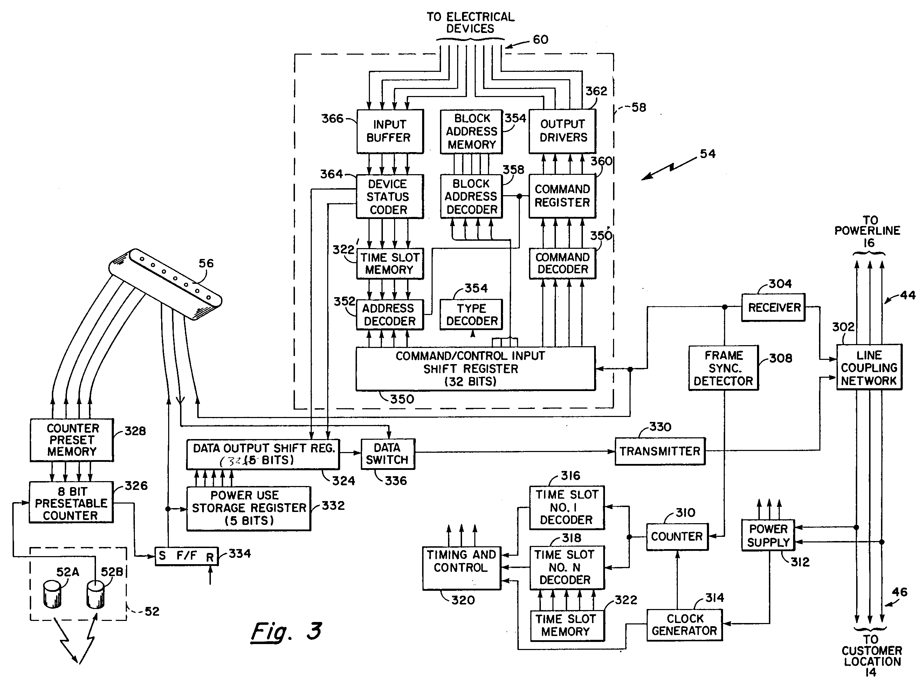

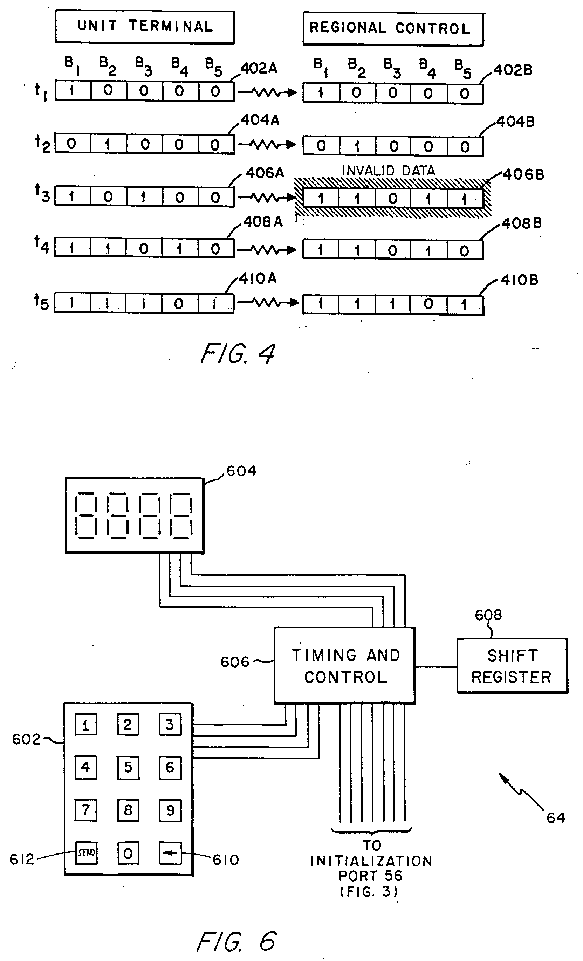

The internal circuitry of terminal unit 10 is shown in greater detail in FIG. 3. Suffice it to say here that terminal unit 10 has a photo sensor 52 (FIG. 3) with a photoemitter 52A and a photodetector 52B. Photoemitter 52A and photodetector 52B are both pointed at calibration wheel 42. The surface of calibration wheel 42 is generally a bright color, say metallic silver, except for dark strip 48. Thus, the light from photoemitter 52A will reflect from calibration wheel 42 and be received at photodetector 52B except when black stripe 48 passes below terminal unit 10. Thus, each time calibration wheel 42 makes one rotation, the output of photodetector 52B will contain a pulse.

Photodetector 52B is connected to terminal electronics 54. Terminal electronics 54 keeps track of the pulses from photodetector 52B to determine the amount of power provided to customer location 14. Terminal electronics 54 also contains circuitry to send and receive messages from regional control center 18 (FIG. 1).

Terminal unit 10 contains an initialization port 56. Initialization port 56 allows an initialization unit (FIG. 4) to be connected to terminal electronics 54. As will be apparent from the following description, terminal electronics 54 requires that certain pieces of data initially be provided to it for proper operation. This data is entered by a human installer through an initialization unit connected to initialization port 56.

Terminal unit 10 optionally contains a load control unit 58. Load control unit 58 makes connection to terminal electronics 54 through pins 62 which can be plugged into terminal unit 10. When load control unit 58 is plugged into terminal unit 10, load control unit 58 responds to commands transmitted by regional control center 18 which command terminal unit 10 to disconnect or reconnect an electrical device at customer location 14.

Turning now to FIG. 3, a block diagram of the circuitry 54 in terminal unit 10 is shown. Terminal unit 10 is connected between input cable 44 and output cable 46 through a line coupling network 302. Line coupling network 302 contains a transformer and other circuitry to pass any signals at the carrier frequency, say 40 kHz, and block any signals at the line frequency, 60 Hz. In this way, signals from regional control center 18 are selected.

The signals from line coupling network 302 pass to receiver 304. Receiver 304 converts the signal at the carrier frequency into a bit stream at baseband frequency. Here, receiver 304 operates on phase shift keyed (PSK) signals.

The received signal passes to synchronization circuit 308. Synchronization circuit 308 detects a particular pattern of bits which signal the start of a "frame". In the system of FIG. 1, communication between a regional control center 18 and each of the plurality of power meters 12 is organized into "frames". Each frame represents a period of time, say about three minutes. The frame is divided into slots, say 2,048. The first slot is set aside for regional control center 18 to send commands to all of the meters 12 connected to it. Each of the remaining slots is assigned to only one of the power meters 12 connected to the regional control center 18. During that time slot, the assigned meter transmits data indicating the amount of power usage recorded by the meter since the last frame.

When the start of a frame is detected by synchronization circuit 308, a signal is provided to counter 310. Counter 310 is a self clearing counter which takes as its input a 60 Hz signal generated by power supply 312. It should be noted that both the regional control center 18 (FIG. 1) and all the power meters 12 derive a timing signal from the 60 Hz power line voltage. Thus, all the circuits are synchronized to the same reference.

Counter 310 counts 60 Hz pulses during the entire frame time. At the end of the frame time, counter 310 resets to zero and stops counting. Counter 310 does not resume counting until synchronization circuit 308 signals the start of another frame.

Time slot 1 decoder 316 is connected to the output of counter 310. Time slot 1 decoder 316 recognizes the values of counter 310 which occur during the first time slot of a frame. Time slot 1 decoder 316 thus produces an output signal which indicates the duration of time slot 1. This signal is provided to timing and control circuit 320. As described above, during time slot 1, information is sent by regional control center 18 to the meters 12. Thus, when time slot 1 decoder 316 indicates the beginning of time slot 1, the bit stream from receiver 304 is passed to load control unit 58 where it is stored in shift register 350 for further processing, which is described below.

The message received during time slot 1 could also relate to the initialization sequence described below. During time slot 1, timing and control circuit 320 also generates commands to have the received bit stream passed to initialization port 56. If an initialization unit is present, the received bit stream is further processed, as described below in conjunction with the description of the initialization unit.

Time slot N decoder 318 is also connected to counter 310. Each of the meters 12 (FIG. 1) connected to one regional control center is assigned a unique time slot. The slot number, say N, assigned to any given meter is stored in the time slot memory 322 for that meter. Time slot N decoder 318 produces a logic HI output signal when the counter 310 takes on values indicating time slot N has been reached. The output returns to logic LO at the end of the time slot.

During time slot N, information can be transmitted by the meter. Thus, in response to the output of time slot N decoder 318, timing and control circuit 320 generates commands to transmit data. Transmitted data, as will be described below, comes from one of two places: shift register 324 indicating power usage or through initialization port 56 when an initialization unit is attached.

Terminal electronics 54 produces data to transmit by tracking power supplied to customer location 14. As described above, photodetector 52B produces one pulse for each rotation of calibration wheel 42. The pulses from photodetector 52B are supplied to counter 326.

Counter 326 is a presetable down counter. As each pulse is received, the value in counter 326 decreases by one. When the value in, counter 326 decrements to zero, counter 326 produces an output pulse to storage register 332. Thereafter, counter 326 is loaded with the value in counter preset memory 328. Counter 326 therefore produces a pulse after a predetermined number of rotations of calibration wheel 42.

That predetermined number is selected based on the unit of power which terminal electronics 54 tracks. For example, if calibration wheel 42 (FIG. 1) makes 100 revolutions for each kiloWatt hour and terminal electronics 54 is to track power in increments of 1 kiloWatt hour, the value 100 is stored in counter preset memory 328. It is important to note that whatever value is selected for counter preset memory 328, it must be large enough that calibration wheel 42 (FIG. 1) cannot make more than that number of revolutions during one frame.

Each output pulse from counter 326 is provided to the set input of flip-flop 334. This pulse puts flip-flop 334 in a state indicating one unit of power has been consumed.

Once each frame, say at the start of the frame, timing and control logic 320 causes the value in flip-flop 334 to be shifted into shift register 332. Then, 334 is set to zero.

Shift register 332 here has five bit positions. Thus, it contains information on power usage over the past five frame times. FIG. 4 shows the contents of shift register 332 at five consecutive times $t_1$, $t_2$, $t_3$, $t_4$, $t_5$ separated by the length of one frame. Word 402A, representing the contents of shift register 332 at time $t_1$, has a 1 in its first location, indicating a unit of electricity was used during the first frame. Word 404A, representing the contents of shift register 332 at time $t_2$, contains a 0 in its first location and the 1 previously at the first location is shifted to the second location. Words 404a indicates that by the end of the second frame, another full unit of power was not consumed.

Thus, at the start of the next frame following when another full unit of power is consumed, a 1 is shifted into the first bit position of register 332. The 1 is shifted through the successive bit positions of shift register 332 and thus stays in shift register 332 for five successive frames. This arrangement provides redundancy for detecting and correcting errors.

FIG. 4 also shows words 402B, 404B, 406B, 408B, and 410B representing words 402A, 404A, 406A, 408A, and 410A as they are received at regional control center 18 (FIG. 1). In the example of FIG. 4, word 406B is erroneously received, such as might be caused by noise on power line 16 (FIG. 1). An error in a bit position is detected by comparing a bit position in a word with bit positions in other words which should have the same value. For example, bits $B_1$ in word 402B, $B_2$ in 404B, $B_3$ in 406B, $B_4$ in 408B, and $B_5$ in 410B all should have the same value. In the example, bit $B_3$ in word 406B is 0 while the bits in the other words are 1. Bit $B_3$ in word 406B is therefore changed to a 1. Thus, by comparing bits in a word to bits in other words which should have the same value, errors are detected and can be corrected. Control/memory circuit 22 (FIG. 1) is programmed to perform this error correcting process.

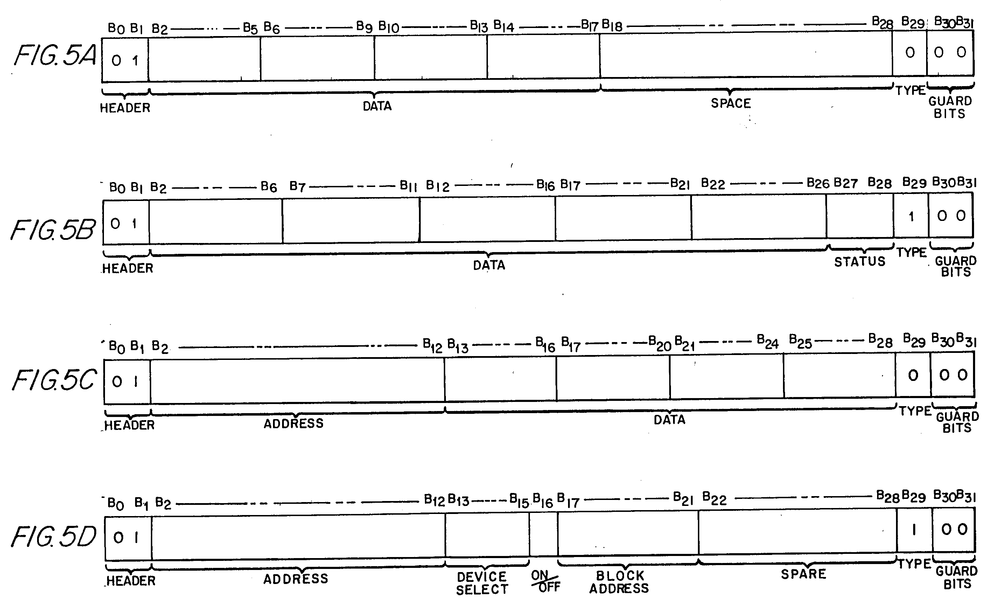

Returning to FIG. 3, it can be seen that 5 bit shift register 332 provides inputs to 32 bit shift register 324. FIG. 5B shows how the bits are loaded into shift register 324 to make up one message transmitted to regional control center 18 for a message indicating power usage at a customer location 14.

One copy of the 5 bits from shift register 332 is loaded into bit locations $B_2...B_6$ of shift register 332. The same data is repeated four more times at bit locations $B_7...B_{11}$, $B_{12}...B_{16}$, $B_{17}...B_{21}$, and $B_{22}...B_{26}$. This further redundancy in the way data is sent to regional control center 18 (FIG. 1) allows the detection and correction and errors in the transmission of data. Very simply, the true value of data sent is determined by selecting the bit value which the majority of corresponding bit positions here. For example, bit positions $B_2$, $B_7$, $B_{12}$, $B_{17}$, and $B_{22}$ should all have the same value. If, for example, four of those bit positions have a value of 1 but one has a value of 0, the value of 1 is selected as the true value of the first bit position. Control/memory circuit 22 (FIG. 1) is designed to select the appropriate value of each bit position.

FIG. 5B shows that 25 of the 32 bit positions in shift register 324 are taken up by data. Bit positions $B_0$ and $B_1$ contain a header, which are always 0 and 1, respectively. Bit positions $B_{30}$ and $B_{31}$ contain guard bits which are always set to 0. These bits, as in conventional communication systems, help avoid lost data by ensuring that no two messages are transmitted at the same time. Bit position $B_{29}$ is set to 1 to indicate that the message contains information about power usage. Bit positions $B_{27}$ and $B_{28}$ contain status information. As shown in FIG. 3, the values of these bits are set by device status coder 364. The operation of device status coder 364 is described below.

At time slot N during a frame, timing and control circuit 320 generates control signals to shift register 324 and data switch 336. Those control signals send the information from shift register 324 to transmitter 330 for transmission as a DPSK signal on power line 16 (FIG. 1).

Regional control center 18 (FIG. 1) receives the information. Because regional control center 18 receives the information during a particular time slot of a frame, it can associate the information with one particular customer location 14 (FIG. 1). Control/memory circuit 22 contains at least one memory location for each customer location. If the message received at regional control center 18 indicates another whole unit of power has been consumed, control/memory circuit 22 increments by one the value stored in that memory location. Thus, it can be seen that the messages from a meter 12 indicate incremental power used. These increments of power are recorded at the regional control center 12 which stores the cumulative power usage for each customer location 14.

This protocol for transmitting data allows other functions to be performed. For example, regional control center 18 (FIG. 1) can perform time of day billing. In time of day billing, the price of electricity is increased during certain hours of the day when peak power usage generally occurs. Control/memory circuit 22 (FIG. 1) would thus contain two memory locations for each customer location 14, one for storing power usage during peak hours and one for storing power usage during off-peak hours. When a message indicating one unit of power was used during a peak hour, the memory storing usage during peak hours would be incremented. Conversely, during off-peak hours, the other memory location would be incremented.

Sending messages indicating incremental power usage also allows detection of theft of services. If a customer tampered with a meter 12 such that it temporarily stopped recording power used, the power meter 12 would send messages indicating no power was being used. If such a message is received from one meter, say for 10 consecutive frames, it is likely that the meter was tampered with. Regional control center 18 (FIG. 1) can be programmed to recognize such a condition and send a message to utility control center 26 (FIG. 1) from which a person could be dispatched to inspect the meter.

Power outages can also be detected using the protocol described. Regardless of how much power is used, each meter should transmit a message during its assigned slot in every frame. As shown in FIG. 5B, that message will have as a minimum a header, a type and guard bits. If regional control center 18 does not receive such a message during the assigned time slot for a particular meter 12, an error condition is present. Very likely, the error is that power is no longer being supplied to that customer location. If no power is being provided because a power line has been knocked down, more than just one customer location will be without power and more than one location will not be transmitting messages during their assigned time slots. Regional control center 18 can be programmed to associate each power line with a certain set of customer locations connected to that power line. If all the customer locations associated with a power line stop sending messages, regional control center 18 can identify which power line is not working. Regional control center 18 can then send a message to utility control center 26 indicating a power line is not working and repair crews can be dispatched.

The messages indicating incremental power usage are also useful in performing load control functions. The message from each customer location tells how much power is being used at that location. By adding up the power usage at all customer locations, the total instantaneous power usage can be quickly determined. If the total instantaneous power usage is too high, regional control center 18 can send commands to reduce power usage.

As described above, each terminal unit 10 optionally contains a load control unit 58. Load control unit 58 turns off electrical devices at customer location 14 in response to a command to cut power usage. FIG. 3 shows the circuitry for load control unit 58. Also as described above, any message received during slot 1 is assumed to be a command. The message is stored in shift register 350.

FIG. 5D shows the format of a command. The command has a header in bit positions $B_0$ and $B_1$ and guard bits in bit position $B_{30}, B_{31}$. Bit $B_{29}$, when set to 1, indicates the command is for a load control unit 58. Bits $B_2...B_{12}$ contain the address of the meter 12 to which the command applies. Here, there are 2,047 meters connected to regional control center 18. The address tells which one of the 2,047 meters should respond to the command. However, FIG. 5D shows the command has a second type of address, a block address in bit positions $B_{17}...B_{21}$. Groups of meters are assigned to different blocks. Each block has its own address. When the address for a particular block is included in bit positions $B_{17}...B_{21}$, all meters in that block respond to the command.

FIG. 5D shows that bits $B_{13}$, $B_{14}$, and $B_{15}$ of

the message are set aside to indicate which electrical device is affected by the command. For example, device 001 might be a refrigerator, device 010 might be an air conditioner, etc. Bit $B_{16}$ contains a 1 if the device is to be allowed to draw power and a 0 if power to the device is to be disconnected.

Referring again to FIG. 3, the circuitry to respond to the command is shown. Type decoder 354 checks the value of bit $B_{29}$. If that bit has a value of 1, type decoder 354 allows load control unit 58 to respond to the command.

Address decoder 352 compares the address in bit positions $B_2...B_{12}$ to the address assigned to the meter. That address is stored in time slot memory 322' which is identical to or can even be the same memory as time slot memory 322. If the address in the message matches the address in time slot memory 322', address decoder 352 sends a signal to command register 360 allowing it to accept the command. In a similar fashion, if the block address in bit positions $B_{17}...B_{21}$ matches a block address in block address memory 359, block address decoder 358 sends a signal to command register 360 allowing it to process the command.

Command decoder 356 has as its inputs bits $B_{13}...B_{16}$. These bits tell which devices should be turned on or off. Each such device is connected to load control unit 58 through one of a set of load control wires 60. Command decoder 356 determines the correct values for load control wires 60 and supplies those values to command register 360. Command register 360, provided that either address decoder 352 or block address decoder 358 indicated that the unit should respond to the command, stores the values computed by command decoder 356.

The values in command register 360 are supplied to output driver 362. Output driver 362 provides the appropriate signal levels on load control lines 60.

Load control lines 60 can run to individual electrical devices. In this arrangement, the electrical devices must be modified to contain switching circuitry which can turn on and off the power in response to the values on load control lines 60. Alteratively, load control lines 60 can run to modified circuit breakers of the type described in U. S. Patent No. 4,456,832 entitled "Circuit Breaker Control Device" in the name of Greer, et al., which is hereby incorporated by reference. As yet another alternative, output driver 362 could couple a special tone onto line 46. This tone would thus be coupled to every electrical device connected to through meter 12. However, certain of the devices would include circuitry that would detect the tone and discontinue or resume drawing power.

Here, it is shown that load control unit 58 accepts lines from electrical devices through input buffer 366. These lines might carry information indicating if a particular electrical device is functioning or if it is turned on. The lines are applied to device status coder 364. Device status coder converts the lines into a two bit code. As described above, that code is put into bit positions $B_{27}$ and $B_{28}$ (FIG. 5B) of shift register 350 and are transmitted to regional control center 18 (FIG. 1).

The foregoing has described operation of terminal unit 10. It has been assumed that the terminal unit 10 was already installed and initialized. When installing a terminal unit 10, it is necessary to assign that unit a time slot, a block address, specify how many rotations of calibration wheel 42 (FIG. 1) represents on circuit of power, and also to indicate to the regional control center 18 (FIG. 1) the cumulative power already used at customer location 14 at the time of installation. For this purpose, an initialization port 56 is provided. Circuitry of an initialization unit which plugs into initialization port 56 is shown in FIG. 6. Initialization unit 64 is used by the person who installs terminal unit 10 to an existing meter.

Initialization unit 64 contains a key pad 602 with which an installer can enter data and an LCD display 604 for verifying correct entry of data. Key pad 602 and LCD display 604 are connected to timing and control circuit 606. Key pad 602 and display 604 operate in a conventional fashion. Data entered on key pad 602 is shown on display 604. Key pad 602 has an editing key 610 for erasing a digit entered in error and a send key 612 for indicating all digits of a datum have been entered correctly.

Timing and control circuit 606 is any suitable known digital logic circuit. It might be a conventional microprocessor or a collection of digital integrated circuits. Timing and control circuit 606 controls the initialization sequence described below. In one embodiment, it may put messages or codes on display 604 indicating what data is to be entered.

As part of the initialization, the installer enters the slot number assigned to terminal unit 54 (FIG. 3). That number is passed by timing and control circuit 606 through initialization port 56 to time slot memories 322 and 322' (FIG. 3). A block address is stored in block address memory 359 (FIG. 3). Also, the value for counter preset memory 328 (FIG. 3) is entered in a like fashion. The or each time slot memory is preferably a non-volatile memory register.

Once terminal unit 54 is installed, it sends messages to regional control center 18 (FIG. 1) indicating the increments of power used. However, regional control center 18 (FIG. 1) cannot compute cumulative power measured by meter 12 unless it is provided with the reading on meter 12 when terminal unit 10 is installed. The installer enters via key pad 602 the current reading on dials 40. Any convenient format for data entry can be used. For example, timing and control circuit 606 might place a symbol on display 604 indicating the meter reading should be entered.

Timing and control circuit 606 receives the digits entered via key pad 692 and echoes them on display 604.

Also, the digits are placed in 32 bit shift register 608 according to the format in FIG. 5A. The contents of shift register 608 is transmitted to regional control center 18 (FIG. 1). The individual digits are placed in bit locations $B_2...B_5$, $B_6...B_9$, $B_{10}...B_{13}$, and $B_{14}...B_{17}$. Bits $B_0$ and $B_1$ are a header and bits $B_{30}$ and $B_{31}$ are guard bits. Bit $B_{29}$ is set to 0, indicating the shift register contains a message from initialization unit 64.

When the correct data is loaded into shift register 608, timing and control unit 606 sets a control line on data switch 336 (FIG. 3) through initialization port 56. As described above, at the appropriate time slot in a frame for terminal unit 10 to transmit data, timing and control circuit 320 (FIG. 3) asserts a control line which passes through initialization port 56 (FIG. 3) to timing and control 606. In response, timing and control circuit 606 transfers the contents of shift register 608 through initialization port 56 (FIG. 3) to data switch 336 (FIG. 3). From data switch 336, the bits from shift register 608 are transmitted to regional control center 18 (FIG. 1).

When the message is received at regional control center 18 (FIG. 1), the data indicating the current meter reading is stored in the appropriate memory location in control/memory circuit 22 (FIG. 1). Regional control center 18 (FIG. 1) can thereafter compute cumulative power used at meter 12.

To ensure correct data is stored in control/memory circuit 22 (FIG. 1), control memory circuit 22 (FIG. 1) sends a message back to initialization unit 64 (FIG. 6). The message is shown in FIG. 5C. Bits $B_2...B_{12}$ contain the slot number assigned to the meter. Bits $B_{13}...B_{28}$ repeat the data sent to regional control center 18 (FIG. 1). Bit $B_{29}$ is set to 0, indicating the message is for initialization unit 64. The message is sent during time slot 1 of the next frame.

As described above, time slot 1 decoder 316 (FIG. 3) causes all messages received during time slot 1 to be received. Timing and control circuit 320 (FIG. 3) sets control lines, causing the message to be accepted by timing and control circuit 606 (FIG. 6).

Timing and control circuit 606 compares the data received in the message with the data sent. If the data matches, a display 604 is set to indicate the initialization was completed. If the data does not match, or a message as in FIG. 5C is not received within say two frame times, the bits in shift register 608 can be retransmitted. If after retransmission, a message as in FIG. 5C with data matching the data in shift register 605 is not received, display 604 can be set to a state indicating an error. The installers can then take corrective action.

In the foregoing description, it was assumed that signals impressed on power line 16 at meter 12 would reach transceiver 20 in regional control center 18, and vice versa. It may be that attenuation over power line 16 is small enough not to interfere with propagation of the signal. However, the exact amount of attenuation depends on many factors such as specific components used by the power company. If the attenuation is too large, certain techniques might be used to reduce it. Two major sources of attenuation are transformers, such as transformer 34 (FIG. 1) and power factor correction capacitors, such as capacitor 36. Transformers act to interrupt the signal path. Capacitors act as a shunt in the signal path.

To ameliorate the attenuation associated with a capacitor, a relatively small inductor can be connected in series with the capacitor. The inductor should present a very low impedance to the 60Hz power line frequency but a high impedance to the carrier frequency.

To ameliorate the attenuation associated with a transformer, a fiber optic bridge can be used. The fiber optic bridge has a transceiver on both the primary and secondary sides of the transformer. The two transformers are linked by a fiber optic link (or other suitable communication link).

Information signals received on one side of the transformer are received by the transceiver at that side of the transformer. The signals are sent over the fiber optic link to the transceiver at the other side of the transformer. The signals are then retransmitted. Thus, the transformer does not attenuate information signals when transceivers are employed.

The foregoing has described specific embodiments of the invention. Based on the foregoing, one of skill in the art will appreciate that various modifications might be made to the preferred embodiment without departing from the scope of the invention. For example, a microprocessor might be used in place of discrete logic components.

In the disclosed embodiment, each terminal unit is connected at a customer location. It is possible that a terminal unit with a load control unit might be advantageously connected at other points in the network to perform distribution automation. For example, the load on the power grid could be reduced by replacing transformer 34 with a transformer with a different turns ratio. In that case, the terminal unit would control a switching circuit which could disconnect one transformer and reconnect a different transformer. The above described load control circuitry could still be used. As another example, power factor correction capacitors might he switched into the network by circuitry such as described herein. It will be appreciated, then, that the circuitry described herein can be used at any switchable point in a power distribution network.

**Claims**

1. A terminal unit adapted for mounting to an electric power meter of the type having a calibration wheel, said unit having circuitry comprising:
   a) a photodetector means for producing a pulse for each rotation of the calibration wheel;
   b) means for counting pulses produced by the photodetector means and for setting a logic signal in a first state after a predetermined number of pulses; and
   c) means for transmitting a message indicating the value of the logic signal and setting the logic signal to a second state.

2. The terminal unit of Claim 1 additionally comprising a port adapted to receive an input unit having an input means and an output means, said port providing conducting paths for signals from the input means to the circuitry and to the output means from the circuitry.

3. The terminal unit of Claim 2 wherein the input means comprises a key pad and the output means comprises a numeric display.

4. The terminal unit of Claim 3 wherein the circuitry comprises means for receiving messages.

5. The terminal unit of Claim 4 additionally comprising:
   a) a first housing enclosing the circuitry; and
   b) a second housing, attached to the first housing, enclosing circuit means for actuating control lines in response to a message received at the receiving means.

6. The terminal unit of Claim 5 wherein the control lines are connected to switches which disconnect the power supplied to electrical appliances.

7. The terminal unit of Claim 6 wherein the terminals unit is mounted to an electric power meter.

8. The terminal unit of Claim 7 wherein the terminal unit is coupled to a power line and the transmitting means transmits a message on the power line.

9. In a system for distributing electricity alternating at a predetermined frequency, the system being of the type having a plurality of electric power meters connected through power lines to a central point, apparatus comprising:
   a) a control station connected to the power line, said control station containing a receiver and a transmitter;
   b) a plurality of terminal units, each connected to one of the plurality of meters and containing:
      (i) a transmitter; and
      (ii) means for receiving a control signal from the control station and computing, from the predetermined frequency of the electricity on the power line, a predetermined time after the control signal and for enabling the transmitter at the predetermined time, wherein the predetermined time is different for each of the plurality of terminal units.

10. The system of Claim 9 wherein each terminal unit additionally comprises a non-volatile memory register and the predetermined time for each terminal unit equals a predetermined slot time multiplied by the value in the non-volatile memory register.

11. The system of Claim 10 additionally comprising:
   a) a port; and
   b) control means to transfer a value applied to the port to the non-volatile memory register.

12. The system of Claim 11 wherein none of the non-volatile memory registers in the terminal units contains a first predetermined value.

13. The system of Claim 12 wherein the control station transmits a command message to all of the terminal units at a time following the control signal by a time equal to the predetermined value and the slot time.

14. The system of Claim 13 wherein:
   a) the command message contains an address field; and
   b) each terminal units contains:
      (i) means for comparing the address field to a value assigned to the terminal unit; and
      (ii) means, responsive to the comparing means, for enabling the terminal unit to respond to the command message.

15. The system of Claim 14 wherein each terminal comprises a load control unit comprising:
   a) means for receiving the command message and means for selectively actuating a plurality of switching mechanisms in accordance with the values of fields in the command message.

16. A method of operating an electric power distribution system supplying power to a plurality of customer locations, the system being of the type having a plurality of terminal units, one at each customer location, connected to a power line carrying an a.c. signal and coupled to a regional controller, the method comprising the steps of:
   a) transmitting a message from the regional controller simultaneously to all of the terminal units;
   b) developing at each terminal unit a timing signal from the a.c. signal on the power line and determining from the timing signal the passage of a predetermined period of time, wherein the predetermined period of time is different for each terminal unit; and
   c) transmitting, from each terminal unit after the predetermined period of time, a message to be received at the regional controller.

17. The method of Claim 16 wherein the message to be received comprises a first type message having a plurality of fields comprising:
   a) a field indicating that the message is the first type message; and
   b) a field indicating power used at a customer location.

18. The method of Claim 16 wherein the field indicating power used comprises a plurality of subfields, each containing the same value.

19. A method of operating a power distribution system of the type having a plurality of meters with a terminal unit attached to each meter and a control center coupled to the terminal units, the method comprising the steps of:
   a) under normal operating conditions, transmitting from each terminal unit at intervals of time a message comprising a first field having a first value when a full unit of electric power has been measured by the meter to which the terminal unit is attached since the last message comprising a field with the first field having the first value; and

b) receiving, at the control center, the messages transmitted by the plurality of terminal units and increasing by one unit a stored value associated with each terminal unit when the first field of the message from the terminal unit has the first value.

20. The method of Claim 19 additionally including the step of checking during each interval for a terminal unit for which no message is received.

21. The method of Claim 20 additionally comprising the step of indicating a fault condition associated with a terminal unit when no message is received from that terminal after at least one interval.

22. The method of Claim 20 wherein the terminal units are connected to the control unit over a plurality of power lines, each of the lines having a plurality of terminals connected thereto, the method additionally comprising the step of:

indicating a fault condition associated with one of the plurality of lines when no messages are received during at least one interval from the terminal units connected to the line.

23. The method of Claim 19 additionally comprising the step of transmitting, at the beginning of each interval, a message from the control center simultaneously to all of the terminal units.

24. The method of Claim 19 additionally comprising the steps of:

a) connecting an input unit to a terminal unit;

b) entering through the input unit the reading on the meter;

c) transmitting a message to the control center indicating the reading on the meter; and

d) storing, as the stored value, the value in the message.

25. The method of Claim 19 additionally comprising the step of:

computing the instantaneous power measured by the plurality of meters by counting the number of terminal units generating messages having the first field with the first value.

26. The method of Claim 25 additionally comprising the step of, when the number of counted terminal units exceeds a predetermined threshold, sending commands from the control center to a portion of the terminal units which cause each terminal unit to reduce the amount of power used by devices connected to the meter associated with the terminal unit.

Fig. 1

*FIG. 2*

_Fig. 3_

| | | UNIT TERMINAL | | | | | | REGIONAL CONTROL | | | |
|---|---|---|---|---|---|---|---|---|---|---|---|

| | $B_1$ | $B_2$ | $B_3$ | $B_4$ | $B_5$ | | | $B_1$ | $B_2$ | $B_3$ | $B_4$ | $B_5$ | |
|---|---|---|---|---|---|---|---|---|---|---|---|---|---|
| $t_1$ | 1 | 0 | 0 | 0 | 0 | 402A | → | 1 | 0 | 0 | 0 | 0 | 402B |
| $t_2$ | 0 | 1 | 0 | 0 | 0 | 404A | → | 0 | 1 | 0 | 0 | 0 | 404B |
| $t_3$ | 1 | 0 | 1 | 0 | 0 | 406A | → | 1 | 1 | 0 | 1 | 1 | 406B INVALID DATA |
| $t_4$ | 1 | 1 | 0 | 1 | 0 | 408A | → | 1 | 1 | 0 | 1 | 0 | 408B |
| $t_5$ | 1 | 1 | 1 | 0 | 1 | 410A | → | 1 | 1 | 1 | 0 | 1 | 410B |

*FIG. 4*

*FIG. 6*

604

602

612 SEND  0  ← 610

606 TIMING AND CONTROL

608 SHIFT REGISTER

TO INITIALIZATION PORT 56 (FIG. 3)

64

FIG.5A

FIG.5B

FIG.5C

FIG.5D

EP 0 493 964 A2